# EUROPEAN PATENT APPLICATION

(11) **EP 4 832 500 A1**
(43) Date of publication of application: **28.10.2026**
(21) Application number: 24917334.5
(22) Date of filing: 20.12.2024
(51) Int. Cl.: H04N 23/67, H04N 23/68, H04N 23/54, H04N 23/55, H04N 25/11, G03B 5/00, H10F 39/00

(54) **ELECTRONIC DEVICE COMPRISING IMAGE SENSOR, AND OPERATING METHOD THEREOF**

(30) Priority: 12.01.2024 KR 20240005588; 26.03.2024 KR 20240041308
(71) Applicant: Samsung Electronics Co., Ltd., Suwon-si, Gyeonggi-do 16677 (KR)
(72) Inventor: PARK, Jaehyoung, Suwon-si Gyeonggi-do 16677 (KR); JEONG, Sangbum, Suwon-si Gyeonggi-do 16677 (KR); WON, Jonghoon, Suwon-si Gyeonggi-do 16677 (KR)
(74) Representative: Appleyard Lees IP LLP
(86) International application number: PCT/KR2024/020768
(87) International publication number: WO 2025/150740

(57) **Abstract**

An electronic device according to one embodiment comprises a camera module including: a lens assembly including at least one lens and a sensor that outputs a signal for acquiring motion data corresponding to motion of the electronic device; an image sensor; and an optical image stabilizer (OIS) for moving the lens assembly and/or the image sensor in order to perform an optical image stabilization operation on the basis of the motion data. The electronic device can perform an autofocus function on the basis of autofocus data corrected on the basis of parameters for the optical image stabilization operation.

## Description

### [Technical Field]

The disclosure relates to a technology for performing an auto focus (AF) function in an electronic device comprising an image sensor.

### [Background Art]

As high-resolution modes are demanded, methods for enhancing the AF function using image sensors are proposed. Recently, image sensors are being developed to increase the number of pixels while reducing sizes of pixels due to restrictions on camera arrangement structures. Particularly, as image sensors having not only simple high-resolution modes but also high AF performance are demanded, pixel structures capable of phase difference detection for all pixels are proposed.

An electronic device employing an AF method may include an image sensor in which two photodiodes (PDs) having a 2x1 array are disposed under a single micro lens, and may perform the AF function by classifying AF data outputted from each PD into left data and right data and focusing using a phase difference therebetween. However, as the demand for structures with high resolution increases due to the reduced size of the PD, a structure in which four PDs having a 2x2 array rather than the 2x1 array share a single micro lens is proposed. In this case, phase differences in the horizontal and vertical directions may be known so that there is an advantage of further enhancing AF performance with the advantage of high resolution.

Meanwhile, output from PD pixels may cause a great difference in sensitivity depending on a chief ray angle (CRA) of incident light, and, if the values of PD pixels are used as they are in order to generate actual image data, a deviation of pixel values may be caused depending on physical positions of a lens and pixels.

The above information is presented as related art information only to assist with understanding of the disclosure. No determination or assertion is made as to whether any of the above might be applicable as prior art with regard to the disclosure.

### [Disclosure of Invention]

### [Solution to Problem]

According to an embodiment, an electronic device may include a sensor, a camera module, a processor, and a memory. The sensor may output a signal for acquiring motion data on a motion of the electronic device. The camera module may include a lens assembly, an image sensor, and an optical image stabilizer (OIS). The lens assembly may include at least one lens. The optical image stabilizer may be configured to move at least one of the lens assembly or the image sensor to perform an optical image stabilization (OIS) operation based on the motion data. The memory may store instructions that are executable by the processor. The instructions may be executed by the processor to cause the electronic device to acquire first AF data from the image sensor. The instructions may be executed by the processor to cause the electronic device to generate second AF data by correcting the first AF data based on a parameter for the OIS operation. The instructions may be executed by the processor to cause the electronic device to perform an auto focus (AF) function based on the second AF data.

According to an embodiment, an operating method of an electronic device may include outputting a signal for acquiring motion data corresponding to a motion of the electronic device. The operating method may include controlling a lens assembly or an image sensor to perform an optical image stabilization (OIS) operation based on the motion data. The operating method may include acquiring first AF data from the image sensor, and generating second AF data by correcting the first AF data based on a parameter for the OIS operation. The operating method may include performing an auto focus (AF) function based on the second AF data.

According to an embodiment of the disclosure, a computer-readable non-transitory recording medium may store at least one command and/or instructions that, when executed, cause an electronic device to perform the above-described method or operations of the electronic device.

### [Brief Description of Drawings]

FIG. 1 is a block diagram of an electronic device in a network environment according to various embodiments.
FIG. 2 is a block diagram illustrating a camera module according to various embodiments.
FIG. 3 is a view illustrating a main hardware configuration of an electronic device according to an embodiment.
FIG. 4 is a cross-sectional view of a pixel array of an image sensor according to an embodiment.
FIG. 5 is a view to explain the influence of shading on an image sensor according to an embodiment.
FIG. 6 is a view illustrating examples of shading patterns detected according to an operation of an optical image stabilizer.
FIG. 7 is a flowchart illustrating an operating method of an electronic device according to an embodiment;
FIGS. 8 and 9 are views illustrating optical image stabilization (OIS) operations of an electronic device according to an embodiment.
FIG. 10 is a view illustrating examples of determining whether to perform shading correction according to an OIS operation direction when detecting a phase difference in the horizontal direction.
FIG. 11 is a view illustrating an example of a weighting determined based on an OIS position according to an embodiment.

### [Mode for the Invention]

Hereinafter, embodiments of the disclosure will be described in detail with reference to the accompanying drawings. The advantages and features of the disclosure and ways to achieve them will be apparent by making reference to embodiments as described below in detail in conjunction with the accompanying drawings. However, the disclosure is not limited to the embodiments set forth below, but may be implemented in various different forms and is defined only by the scope of the appended claims. Throughout the specification, the same or like reference numerals indicate the same or like elements.

All of the terms used herein (including technical or scientific terms) may have the meanings that are generally understood by a person skilled in the art unless they are defined otherwise. Terms, which are generally used and defined in a dictionary, should not be interpreted in an idealized or overly formal way, unless expressly so defined herein in the disclosure. Terms used in the disclosure are used to describe embodiments and are not intended to limit the disclosure. The terms of a singular form may include plural forms unless otherwise specified.

The terms "comprises" and/or "comprising" used in this specification indicate that components, steps, operations, and/or elements mentioned do not preclude the presence or addition of one or more other components, steps, operations, and/or elements.

In an embodiment, there are provided an electronic device which is capable of correcting a pattern generated due to mismatch between an incident angle of light entering a lens (lens incident angle) and an incident angle of light entering a sensor (sensor incident angle), and an operating method thereof.

In an embodiment, there are provided an electronic device which is capable of improving accuracy when operating an auto focus function by correcting a pattern generated due to mismatch between a lens incident angle and a sensor incident angle, and an operating method thereof.

The technical objects to be achieved by the disclosure are not limited to those mentioned above, and other technical objects that are not mentioned above may be clearly understood to those skilled in the art to which the present discloser pertains.

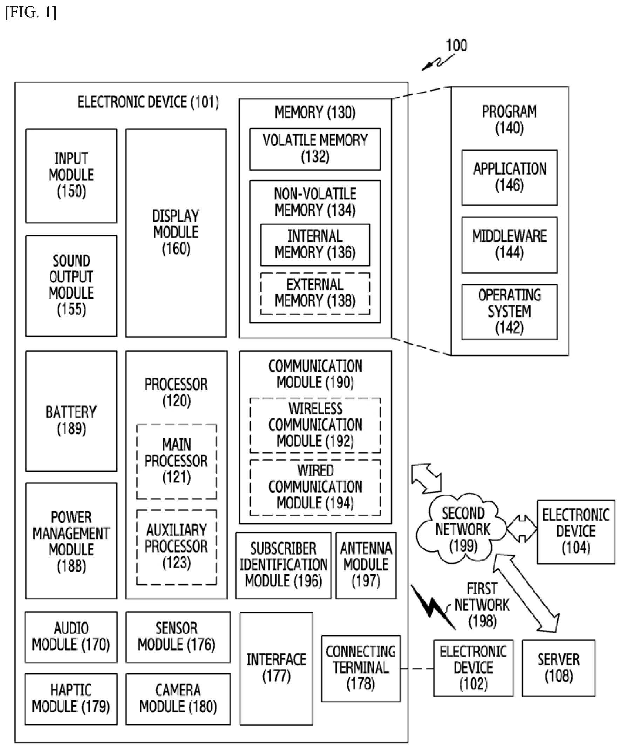

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beamforming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

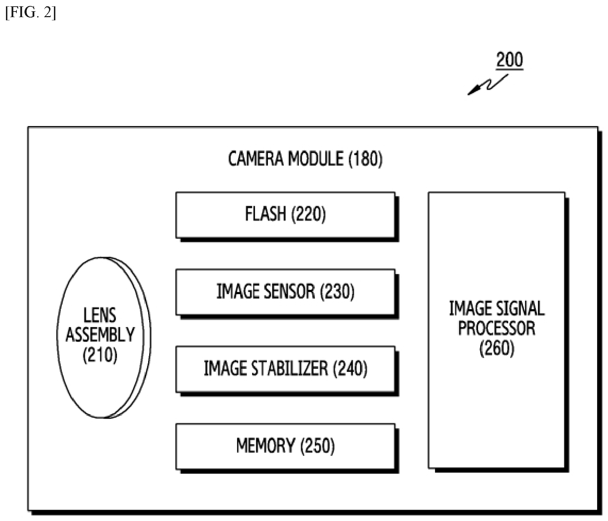

Fig. 2 is a block diagram 200 illustrating the camera module 180 according to various embodiments. Referring to Fig. 2, the camera module 180 may include a lens assembly 210, a flash 220, an image sensor 230, an image stabilizer 240, memory 250 (e.g., buffer memory), or an image signal processor 260. The lens assembly 210 may collect light emitted or reflected from an object whose image is to be taken. The lens assembly 210 may include one or more lenses. According to an embodiment, the camera module 180 may include a plurality of lens assemblies 210. In such a case, the camera module 180 may form, for example, a dual camera, a 360-degree camera, or a spherical camera. Some of the plurality of lens assemblies 210 may have the same lens attribute (e.g., view angle, focal length, auto-focusing, f number, or optical zoom), or at least one lens assembly may have one or more lens attributes different from those of another lens assembly. The lens assembly 210 may include, for example, a wide-angle lens or a telephoto lens.

The flash 220 may emit light that is used to reinforce light reflected from an object. According to an embodiment, the flash 220 may include one or more light emitting diodes (LEDs) (e.g., a red-green-blue (RGB) LED, a white LED, an infrared (IR) LED, or an ultraviolet (UV) LED) or a xenon lamp. The image sensor 230 may obtain an image corresponding to an object by converting light emitted or reflected from the object and transmitted via the lens assembly 210 into an electrical signal. According to an embodiment, the image sensor 230 may include one selected from image sensors having different attributes, such as a RGB sensor, a black-and-white (BW) sensor, an IR sensor, or a UV sensor, a plurality of image sensors having the same attribute, or a plurality of image sensors having different attributes. Each image sensor included in the image sensor 230 may be implemented using, for example, a charged coupled device (CCD) sensor or a complementary metal oxide semiconductor (CMOS) sensor.

The image stabilizer 240 may move the image sensor 230 or at least one lens included in the lens assembly 210 in a particular direction, or control an operational attribute (e.g., adjust the read-out timing) of the image sensor 230 in response to the movement of the camera module 180 or the electronic device 101 including the camera module 180. This allows compensating for at least part of a negative effect (e.g., image blurring) by the movement on an image being captured. According to an embodiment, the image stabilizer 240 may sense such a movement by the camera module 180 or the electronic device 101 using a gyro sensor (not shown) or an acceleration sensor (not shown) disposed inside or outside the camera module 180. According to an embodiment, the image stabilizer 240 may be implemented, for example, as an optical image stabilizer. The memory 250 may store, at least temporarily, at least part of an image obtained via the image sensor 230 for a subsequent image processing task. For example, if image capturing is delayed due to shutter lag or multiple images are quickly captured, a raw image obtained (e.g., a Bayer-patterned image, a high-resolution image) may be stored in the memory 250, and its corresponding copy image (e.g., a low-resolution image) may be previewed via the display module 160. Thereafter, if a specified condition is met (e.g., by a user's input or system command), at least part of the raw image stored in the memory 250 may be obtained and processed, for example, by the image signal processor 260. According to an embodiment, the memory 250 may be configured as at least part of the memory 130 or as a separate memory that is operated independently from the memory 130.

The image signal processor 260 may perform one or more image processing with respect to an image obtained via the image sensor 230 or an image stored in the memory 250. The one or more image processing may include, for example, depth map generation, three-dimensional (3D) modeling, panorama generation, feature point extraction, image synthesizing, or image compensation (e.g., noise reduction, resolution adjustment, brightness adjustment, blurring, sharpening, or softening). Additionally or alternatively, the image signal processor 260 may perform control (e.g., exposure time control or read-out timing control) with respect to at least one (e.g., the image sensor 230) of the components included in the camera module 180. An image processed by the image signal processor 260 may be stored back in the memory 250 for further processing, or may be provided to an external component (e.g., the memory 130, the display module 160, the electronic device 102, the electronic device 104, or the server 108) outside the camera module 180. According to an embodiment, the image signal processor 260 may be configured as at least part of the processor 120, or as a separate processor that is operated independently from the processor 120. If the image signal processor 260 is configured as a separate processor from the processor 120, at least one image processed by the image signal processor 260 may be displayed, by the processor 120, via the display module 160 as it is or after being further processed.

According to an embodiment, the electronic device 101 may include a plurality of camera modules 180 having different attributes or functions. In such a case, at least one of the plurality of camera modules 180 may form, for example, a wide-angle camera and at least another of the plurality of camera modules 180 may form a telephoto camera. Similarly, at least one of the plurality of camera modules 180 may form, for example, a front camera and at least another of the plurality of camera modules 180 may form a rear camera.

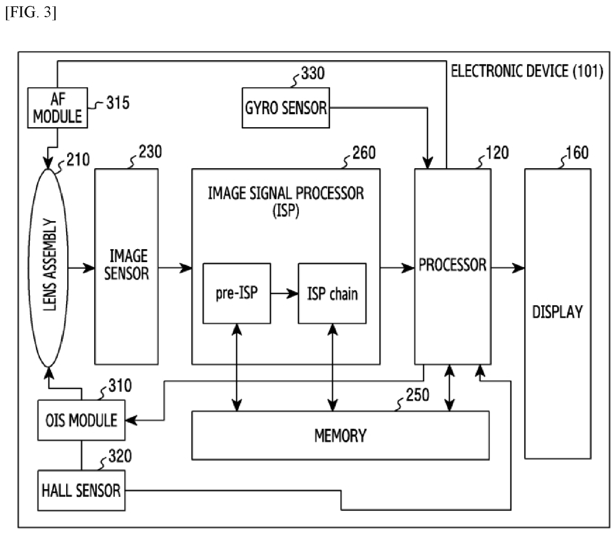

FIG. 3 illustrates a main hardware configuration of an electronic device according to an embodiment. In explaining FIG. 3, the configurations explained in FIGS. 1 and 2 will be described briefly or will not be described.

Referring to FIG. 3, in an embodiment, the electronic device 101 (for example, the electronic device 101 of FIG. 1) may include a lens assembly 210 (for example, the lens assembly 210 of FIG. 2), an image sensor 230 (for example, the image sensor 230 of FIG. 2), an image signal processor 260 (for example, the image signal processor 260 of FIG. 2), a processor 120 (for example, the processor 120 of FIG. 1), a display 160 (for example, the display module 160 of FIG. 1), and a memory 250 (for example, the memory 130 of FIG. 1, the memory 250 of FIG. 2).

According to an embodiment, the lens assembly 210 may vary in terms of the number, arrangement, and type of lenses according to whether it is for a front-facing camera or a rear-facing camera. The front-facing camera and the rear-facing camera may have different characteristics (for example, a focal distance, a maximum magnification, etc.) according to the type of the lens assembly 210.

According to an embodiment, when the image signal processor 260 and the image sensor 230 are physically divided, there may be a sensor interface following standards.

According to an embodiment, the image signal processor 260 may perform image processing with respect to electrically converted image data. Processing in the image signal processor 260 may be divided into pre-ISP (hereinafter, pre-processing) and ISP chain (hereinafter, post-processing). The pre-processing may include 3A processing, lens shading correction, edge enhancement, dead pixel correction, and knee correction. The 3A processing may include at least one of auto white balance (AWB), auto exposure (AE), auto focusing (AF). The post-processing may include at least one of change of a sensor index value, change of a tuning parameter, adjustment of a screen ratio. The post-processing may include processing image data outputted from the image sensor 230 or image data outputted from a scaler. The image signal processor 260 may adjust contrast, sharpness, saturation, dithering of images through the post-processing. Here, the procedure of adjusting contrast, sharpness, saturation may be performed in a YUV color space, and the dithering procedure may be performed in a red green blue (RGB) color space. The image signal processor 260 may transmit image data obtained by performing the post-processing to the memory 250 (for example, a display buffer). The display 160 may display image data stored in the memory 220 (for example, a display buffer) on a display screen under control of the processor 120.

According to an embodiment, the processor 120 may execute/control various functions supported in the electronic device 101. For example, the processor 120 may execute an application by executing a code written in programming languages stored in the memory 250, and may control a variety of hardware. For example, the processor 120 may execute an application stored in the memory 250 to support a photographing function. In addition, the processor 120 may execute a camera module (for example, the camera module 180 of FIG. 1), and may set and support an appropriate photographing mode to allow the camera module 180 to perform an operation intended by a user.

According to an embodiment, the memory 250 may store instructions executable by the processor 120. The memory 250 may be understood as a concept including a component temporarily storing data like a random access memory (RAM) and/or a component permanently storing data like a solid state drive (SSD). For example, the processor 120 may invoke instructions stored in the SSD to implement a software module in a RAM space. In various embodiments, the memory 250 may include various types of memories and an appropriate type of a memory may be employed according to the purpose of a device. According to an embodiment, the memory 250 may include one or more storage media (or one or more storage devices). For example, the memory 250 may include a memory assembly including one or more storage media. For example, the one or more storage media may include a permanent memory such as a hard drive, a flash memory, a read-only memory (ROM), a semi-permanent memory such as a random access memory (RAM), any other suitable type of repository (or a storage assembly), or any combination thereof. The memory 250 may include a cache memory which is one or more different types of memories used to temporarily store data for functions or features of the electronic device 101. As a deconfined example, the cache memory may be included in the processor 120. The memory 250 may be incorporated onto one or more suitable types of components (for example, a subscriber identity module (SIM) card and/or a secure digital (SD) card) which are fixedly embedded in the electronic device 101, repeatedly inserted into the electronic device 101, and removed from the electronic device 101.

According to an embodiment, an application associated with the camera module 180 may be stored in the memory 250. For example, a camera application may be stored in the memory 250. The camera application may support various capturing functions such as photographing, capturing videos, capturing panoramic images, capturing slow motions.

According to an embodiment, the memory 250 may store one or more software applications such as an operating system (or a system software application), a firmware software application, a driver software application, a plug-in (for example, Add-in, Add-on, and/or Applet) software application, and/or any other suitable software applications. For example, the one or more software applications may include instructions executable by at least one processor 120. For example, the memory 250 may store instructions that may be invoked by an application programming interface (API). For example, the memory 250 may store instructions in a library.

According to an embodiment, the processor 120 may display an execution screen of an application executed by the processor 120, or contents such as images and/or videos stored in the memory 250 on the display 160. In addition, the processor 120 may display image data obtained through the camera module 180 on the display 160.

According to an embodiment, the electronic device 101 may include a gyro sensor 330 and a hall sensor 320. For example, the gyro sensor 330 may measure a rotation angle or a slope relative to three axes (for example, X-axis, Y-axis, or Z-axis) of the electronic device 101. However, the gyro sensor is merely an example, and the electronic device 101 may include various sensors (for example, a motion sensor) (for example, the sensor module 176 of FIG. 1) such as an acceleration sensor or a hall sensor.

According to an embodiment, an OIS module 310 may acquire motion data from the gyro sensor 330. The OIS module 310 may acquire information on the degree of shaking of the electronic device 101 by performing an integration operation on the motion data. The OIS module 310 may control the OIS function of the camera module 180 based on the information on the motion data. It is illustrated in FIG. 3 that the OIS module 310 controls the lens assembly 210, BUT this should not be considered as limiting. For example, the OIS module 310 may be configured to control the position of the image sensor 230.

In an embodiment, an auto focus (AF) module 315 may control the AF function of the camera module 180 based on information acquired in the processor. For example, the AF module 315 may control the position of the lens assembly 210 (for example, to adjust a distance between the lens assembly 210 and the image sensor 230) to focus on the image sensor 230. It is illustrated in FIG. 3 that the AF module 315 controls the lens assembly 210, but this should not be considered as limiting. For example, the AF module 315 may be configured to control the position of the image sensor 230.

According to an embodiment, when the camera module 180 employs a lens shift method to move the lens assembly 210, the processor 120 may detect a position to which the lens assembly 210 is moved through the hall sensor 320. According to an embodiment, when the camera module 180 employs a sensor shift method to move the image sensor 230, the processor 120 may detect a position to which the image sensor 230 is moved through the hall sensor 320.

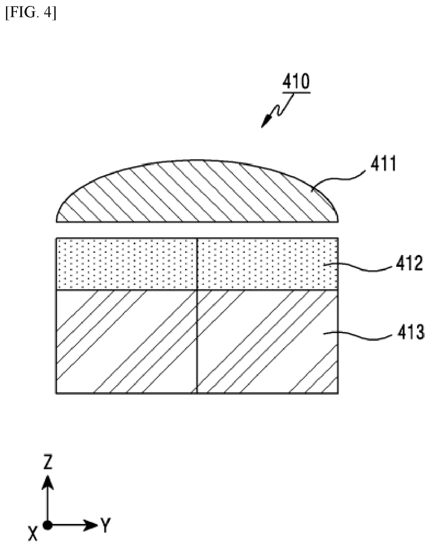

FIG. 4 is a cross-sectional view of a pixel array of an image sensor (for example, the image sensor 230 of FIGS. 2 and 3) according to an embodiment.

Referring to FIG. 4, the image sensor 230 may include a plurality of unit pixels 410. According to an embodiment, each unit pixel 410 may include four or more photo diodes (PDs) 413. According to an embodiment, the plurality of unit pixels 410 may be positioned on a plane that is substantially perpendicular to the Z-axis corresponding to a direction in which light enters. According to an embodiment, a first direction (for example, the X-axis direction) of the plurality of unit pixels 410 may be substantially perpendicular to a second direction (for example, the Y-axis direction) of the unit pixel 410. According to an embodiment, the first direction (for example, the X-axis direction) and the second direction (for example, the Y-axis direction) may be substantially perpendicular to the Z-axis direction.

According to an embodiment, each unit pixel 410 may include a micro lens 411, a color filter 412, and a plurality of photo diodes 413 or a combination thereof. According to an embodiment, each of the plurality of photo diodes 413 may be referred to as a light receiving element. According to an embodiment, the plurality of photo diodes 413 may be referred to as multi photo diodes. The color filter 412 of FIG. 4 may be color filters of the same color channel arranged or may be a color filter including different color channels.

According to an embodiment, the micro lens 411 may collect light entering the micro lens 411. According to an embodiment, the micro lens 411 may adjust a path of light entering the micro lens 411 to allow the light to arrive at each of the plurality of photo diodes 413.

According to an embodiment, the color filter 413 may pass light of a pre-designated color (or color channel). According to an embodiment, the color filter 412 of each of the plurality of photo diodes 413 may pass light of one color (for example, red) among pre-designated colors (for example, red, blue, or green) according to a pre-designated pattern (for example, a Bayer pattern). According to an embodiment, the color filter 412 may block light of colors other than the pre-designated color (or color channel).

According to an embodiment, the plurality of photo diodes 413 disposed at a position corresponding to the single micro lens 411 may be four or more photo diodes. However, this should not be considered as limiting. For example, two photo diodes may be disposed at a position corresponding to the single micro lens 411. In the disclosure, "the photo diodes being disposed at a position corresponding to the micro lens" may mean that the photo diodes are disposed at a position to receive light passing through the micro lens. The plurality of photo diodes 413 may be disposed symmetrically, but this should not be considered as limiting. In the disclosure, the image sensor having the plurality of photo diodes 413 corresponding to the single micro lens 411 may be referred to as a multi-photodiode image sensor. According to an embodiment, each of the plurality of photo diodes 413 may output a value corresponding to incident light. According to an embodiment, each of the plurality of photo diodes 413 may output a value corresponding to incident light based on the photoelectric effect. According to an embodiment, each of the plurality of photo diodes 413 may output a value corresponding to the intensity of incident light (or illuminance) based on the photoelectric effect.

According to an embodiment, each of the plurality of photo diodes 413 may generate an electric charge according to the intensity of incident light (or illuminance) based on the photoelectric effect. According to an embodiment, each of the plurality of photo diodes 413 may output an electric current according to the amount of generated electric charge.

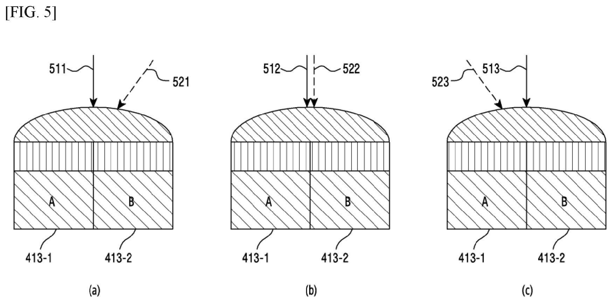

FIG. 5 is a view to explain the influence of shading on an image sensor according to an embodiment.

The amount of light arriving at the photo diodes 413 included in the unit pixel 410 shown in FIGS. 4 and 5 may vary according to an angle of incident light. Accordingly, the unit pixel 410 may detect light entering the micro lens 411 or the photo diodes 413 within a predetermined range. Light entering the image sensor may include a chief ray and a marginal ray. The chief ray may refer to a principal ray among the rays entering the image sensor. The marginal ray may refer to a ray existing in the proximity of the chief ray. The chief ray among the rays arriving at the photo diodes 413 of the image sensor is the strongest, and the intensity of light decreases toward the marginal ray. Light other than light generated due to flare or internal reflection out of the marginal ray may not enter the image sensor. A range of an angle at which a chief ray for detecting light by the unit pixel 410 enters the image sensor (for example, the micro lens 411 or the photo diodes 413) may be referred to as an incident angle range. The chief ray may enter only some photo diodes among the plurality of photo diodes 413 (for example, two photo diodes, four photo diodes) receiving light passing through the micro lens 411 according to the incident angle of the chief ray. Bright light may be detected from the photo diode that the chief ray enters, and dark light may be detected from the photo diode that the chief ray does not enter. As a result, shading may occur.

In addition, the camera module 180 provided with the OIS function may have the chief ray angle of the optical system shifted according to an OIS operation. Shading may occur in the image sensor having the plurality of photo diodes disposed to correspond to the one micro lens according to an OIS operation.

FIGS. 5A, 5B, 5C illustrate the same unit pixel included in the image sensor. Referring to FIG. 5B, when an operation position of an optical image stabilizer (for example, the OIS module 310 of FIG. 3) is a default position (for example, the center of an OIS operation range), a chief ray angle 512 of the image sensor may be substantially consistent with a chief ray angle 522 of a lens. The chief ray angle of the image sensor may refer to an angle of incident light at which light is detected without shading within a unit pixel. The chief ray angle of the lens may refer to an angle at which light passing through a lens assembly (for example, the lens assembly 210 of FIG. 2, the lens assembly 210 of FIG. 3) enters a unit pixel (or a light receiving surface of the image sensor). The lens assembly (for example, the lens assembly 210 of FIG. 2, the lens assembly 210 of FIG. 3) or the image sensor (for example, the image sensor 230 of FIG. 2, the image sensor 230 of FIG. 3) may be moved or tilted due to an operation of the optical image stabilizer. The chief ray may be moved due to the movement of the lens assembly or the image sensor. Angles of the lens assembly and the image sensor that are aligned with each other may be shifted due to the tilt of the lens assembly or the image sensor. Accordingly, the chief ray angle 521, 522, 523 of the lens and the chief ray angle 511, 512, 513 of the image sensor viewed from the unit pixel may be shifted with reference to the unit pixel (for example, the unit pixel 410 of FIG. 4). To this end, the chief ray angles of the image sensor and the lens may be mismatched due to an operation of the optical image stabilizer. FIG. 5A illustrates the chief ray angle 511 of the image sensor and the chief ray angle 521 of the lens when the optical image stabilizer operates in the first direction. FIG. 5C illustrates the chief ray angle 513 of the image sensor and the chief ray angle 523 of the lens when the optical image stabilizer operates in the second direction which is different from the first direction. Referring to FIGS. 5A and 5C, the chief ray of the lens enters the photo diodes 413-1, 413-2 with a different angle from that of the chief ray of the image sensor, causing one photo diode to absorb stronger light than other photo diodes and causing shading in the light detected through the photo diodes 413-1, 413-2. The amount of light detected in the photo diodes 413-1, 413-2 may vary according to the incident angle of the chief ray. When a phase difference is detected with the shading caused by the OIS operation being included in the values detected through the photo diodes 413-1, 413-2, it may not be identified whether the phase difference determined through a correlation operation for the detected values is caused by shading or is caused by an actual phase difference on a subject. Therefore, when the auto focus function is performed based on the phase difference during the operation of the optical image stabilizer, the accuracy of the auto focus function may be reduced. Alternatively, when an image is configured using the data detected from the first photo diode 413-1 and the second photo diode 413-2 as a single pixel value, respectively (for example, when an image is configured without combining data (for example, without a binning operation), the quality of an acquired image may be degraded.

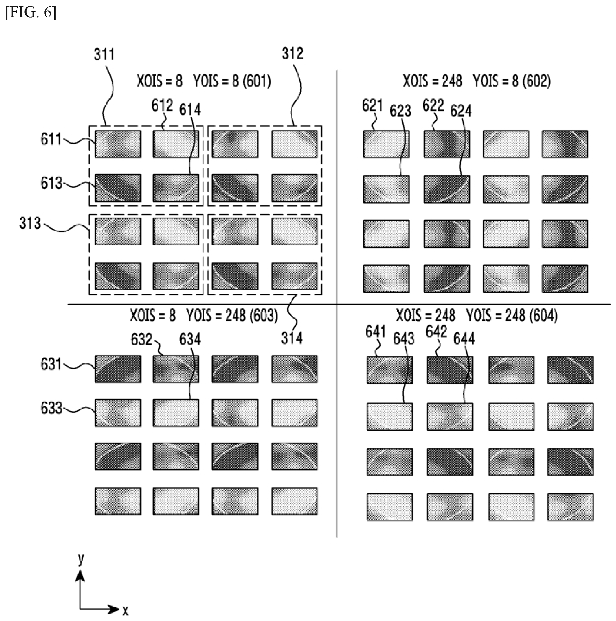

FIG. 6 illustrates examples of shading patterns detected according to an operation of an optical image stabilizer.

FIG. 6 illustrates a shading pattern detected from a plurality of unit pixels 311, 312, 313, 314 each including a single micro lens and four photo diodes corresponding to the micro lens.

FIG. 6 illustrates shading patterns detected in four operational states 601, 602, 603, 604 of an optical image stabilizer (for example, states in which the optical image stabilizer is controlled at different positions). In FIG. 6, XOIS may refer to an X-axis coordinate value indicating an operational state (or an operation position) of the image stabilizer. Alternatively, XOIS may refer to a first displacement value of the center of the lens assembly in the X-axis direction that is defined with reference to the center of the image sensor as a reference point. In FIG. 6, YOIS may refer to a Y-axis coordinate value indicating an operational state (or an operation position) of the image stabilizer. Alternatively, YOIS may refer to a second displacement value of the center of the lens assembly in the Y-axis direction that is defined with reference to the center of the image sensor as a reference point. The first state 601 may indicate a case in which the OIS position in the first direction is about -3 degrees (XOIS=8) and the OIS position in the second direction different from the first direction is about -3 degrees (YOIS=8). The second state 602 may indicate a case in which the OIS position in the first direction is about 3 degrees (XOIS=248) and the OIS position in the second direction is about -3 degrees (YOIS=8). The third state 603 may indicate a case in which the OIS position in the first direction is about -3 degrees (XOIS=8) and the OIS position in the second direction is about 3 degrees (YOIS=248). The fourth state 604 may indicate a case in which the OIS position in the first direction is about 3 degrees (XOIS=248) and the OIS position in the second direction is about 3 degrees (YOIS=248).

In the first state 601, the gain value 612 that is detected from the photo diode in the (+x, +y) direction among the detection values 611, 612, 613, 614 from the photo diodes included in the first unit pixel 311 may have the highest value. To the contrary, the gain value 613 that is detected from the photo diode in the (-x, -y) direction may have the lowest value.

In the second state 602, the gain value 621 that is detected from the photo diode in the (-x, +y) direction among the detection values 621, 622, 623, 624 from the photo diodes included in the first unit pixel 311 may have the highest value. To the contrary, the gain value 624 that is detected from the photo diode in the (+x, -y) direction may have the lowest value.

In the third state 603, the gain value 634 that is detected from the photo diode in the (+x, -y) direction among the detection values 631, 632, 633, 634 from the photo diodes included in the first unit pixel 311 may have the highest value. To the contrary, the gain value 631 that is detected from the photo diode in the (-x, +y) direction may have the highest value.

In the fourth state 604, the gain value 643 that is detected from the photo diode in the (-x, -y) direction among the detection values 631, 632, 633, 634 from the photo diodes included in the first unit pixel 6311 may have the highest value. To the contrary, the gain value 642 that is detected from the photo diode in the (+x, +y) direction may have the lowest value.

The gain value of each photo diode may have a difference from about -80% to about +80% due to the shading pattern.

When the image of 4 PDs is binned, a difference in brightness caused by shading may not matter since an average value is used. However, each gain value may become meaningful data in the process of performing AF or remosaic image processing, so that a difference in brightness unrelated to a subject may matter. The remosaic image processing may refer to an operation of converting the color order of data detected in the image sensor to perform a demosaic image processing operation to convert image data into a color image. In an embodiment, the electronic device may correct a brightness difference caused by shading prior to performing AF or remosaic image processing.

The disclosure provides an electronic device which is capable of efficiently correcting shading caused by a difference between a chief ray angle of a lens and a chief ray angle of an image sensor in the image sensor having a unit pixel of 2PD or 4PD, and an operating method thereof.

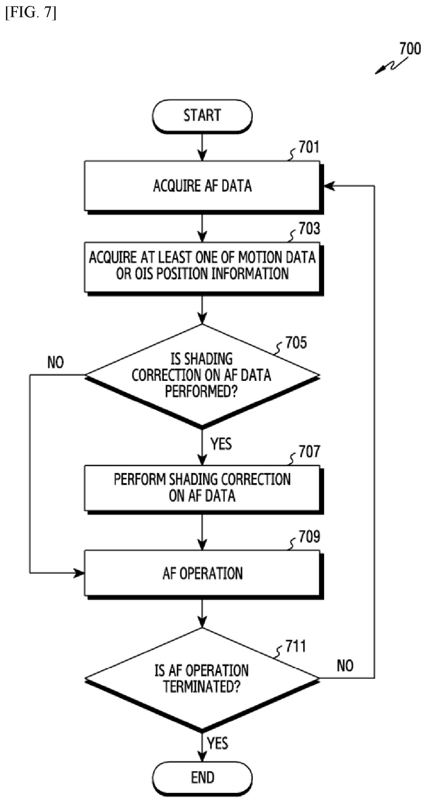

FIG. 7 is a flowchart 700 illustrating an operating method of an electronic device (for example, the electronic device 101 of FIG. 1, the electronic device 101 of FIG. 3) according to an embodiment.

In the disclosure, the operations of the electronic device may be understood as being performed by a processor (for example, the processor 120 of FIG. 1, the processor 120 of FIG. 3) of the electronic device calculating or controlling components of the electronic device by executing instructions stored in a memory (for example, the memory 130 of FIG. 1). In an embodiment, the operations of FIG. 7 may be performed while the electronic device is capturing an image by activating a camera (for example, the camera module 180 of FIG. 1, the camera module 180 of FIG. 2). For example, the operations illustrated in FIG. 7 may be performed while the electronic device is displaying a preview image including an image acquired through the camera by executing a camera application.

According to an embodiment, in operation 701, the electronic device may acquire first AF data from an image sensor (for example, the image sensor 230 of FIG. 2, the image sensor 230 of FIG. 3). For example, a unit pixel according to FIG. 4 (for example, the unit pixel 410 of FIG. 4) may include a multi-photo diode structure in which a phase of light entering PDs (for example, the photo diode 413 of FIG. 4) corresponding to a single micro lens (for example, the micro lens 411 of FIG. 4) is split. The electronic device may acquire the first AF data including phase difference information on at least one phase difference in at least one direction.

According to an embodiment, in operation 703, the electronic device may acquire at least one of motion data or OIS position information. For example, the electronic device may acquire motion data resulting from detection of a motion of the electronic device through a sensor (for example, the sensor module 176 of FIG. 1). The sensor may include, for example, a gyro sensor, but the type of the sensor is not limited thereto. For example, the electronic device may control an OIS position of an optical image stabilizer to compensate for the motion of the electronic device based on the motion data. The electronic device may acquire OIS position information indicating an OIS position of the optical image stabilizer. For example, the electronic device may acquire OIS position information from information detected using a hall sensor (for example, the hall sensor 320 of FIG. 3) disposed in the optical image stabilizer.

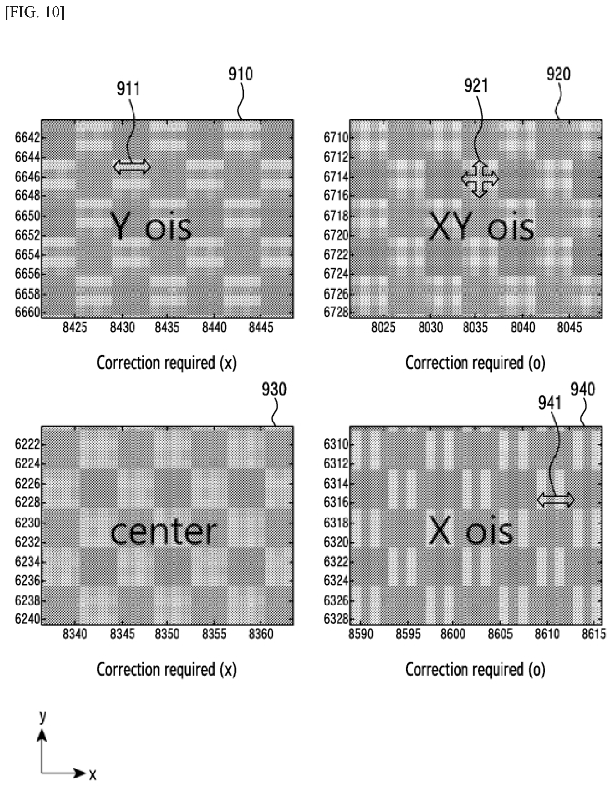

According to an embodiment, in operation 705, the electronic device may determine whether to perform shading correction on the first AF data. The electronic device may be configured to determine whether to perform shading correction based on whether at least one designated condition is satisfied. For example, the electronic device may determine whether a first condition indicating whether a direction corresponding to at least one of motion data or OIS position information (for example, a direction of motion data or a direction in which the OIS is moved) matches a phase difference direction of the first AF data is satisfied. The electronic device may determine whether to perform shading correction based on whether the first condition is satisfied. The first condition will be described in detail below with reference to FIG. 10. For example, the electronic device may determine whether to perform shading correction based on satisfaction of a second condition indicating whether an amount of motion of the electronic device during a designated time period is greater than or equal to a threshold value. For example, the electronic device may determine that the second condition is satisfied based on a value resulting from integration of motion data detected during the designated time period being greater than or equal to a threshold value. For example, the electronic device may be configured to determine to perform shading correction based on both the first condition and the second condition being satisfied. The at least one designated condition may be a condition for determining whether shading correction is required, and may be configured with at least one condition other than the above-described conditions.

According to an embodiment, based on determining not to perform shading correction in operation 705, the electronic device may perform an AF operation based on the first AF data acquired in operation 701. The AF operation may include an operation of controlling an AF actuator (for example, an actuator of the AF module 315 of FIG. 3) included in the camera according to an AF position determined based on the first AF data.

According to an embodiment, based on determining to perform shading correction in operation 705, the electronic device may perform shading correction on the first AF data in operation 707. In an embodiment, the electronic device may perform shading correction on the first AF data based on a look-up table (LUT) stored in the memory. The look-up table may include gain values for correcting the first AF data according to OIS position information based on a shading pattern (for example, the shading pattern illustrated in FIG. 6). The gain values may include a value for correcting a brightness value of a pixel included in the first AF data. The electronic device may acquire a gain value corresponding to OIS position information through the look-up table, and may acquire corrected second AF data by applying the acquired gain value to the first AF data. In an embodiment, the electronic device may adjust a gain value based on an OIS position. For example, the electronic device may determine a weighting based on OIS position information, and may adjust a gain value based on the determined weighting. In operation 709, the electronic device may perform an AF operation based on the second AF data corrected in operation 707. The AF operation may include an operation of controlling the AF actuator included in the camera according to an AF position determined based on the second AF data.

According to an embodiment, in operation 711, the electronic device may determine whether to terminate the AF operation. For example, when a region of interest (ROI) is focused based on the AF operation performed in operation 709, the electronic device may determine to terminate the AF operation. For example, when it is determined that the operation of the camera is inactivated or terminated (for example, when execution of a camera application is terminated), the electronic device may determine to terminate the AF operation. When it is determined that the AF operation is not terminated, the electronic device may resume operation 701 in the flowchart 700.

In an embodiment, the electronic device may be configured to omit operation 705 and to perform operation 707 to perform shading correction.

In an embodiment, the electronic device may change a direction in which phase difference detection is performed, based on a direction of motion data or a direction in which an OIS position is moved. For example, a 4PD image sensor in which PDs of a 2x2 array are arranged to correspond to a single micro lens may detect phase difference data in a first direction (for example, a horizontal direction) or may detect phase difference data in a second direction (for example, a vertical direction). When phase difference detection in the horizontal direction is performed, if a value of motion data in the horizontal direction is constantly positive or negative (or if the integral for a designated period is positive or negative), it means that a motion in the horizontal direction occurs, and therefore, the electronic device may change the direction in which the phase difference detection is performed to the vertical direction. When phase difference detection in the vertical direction is performed, if a value of motion data in the vertical direction is constantly positive or negative (or if the integral for a designated period is positive or negative), it means that a motion in the vertical direction occurs, and therefore, the electronic device may change the direction in which the phase difference detection is performed to the horizontal direction. In an embodiment, when the direction in which the phase difference detection is performed is changed, the electronic device may be configured to omit operation 707 to correct shading if the motion of the electronic device corresponding to the corresponding direction is minimal.

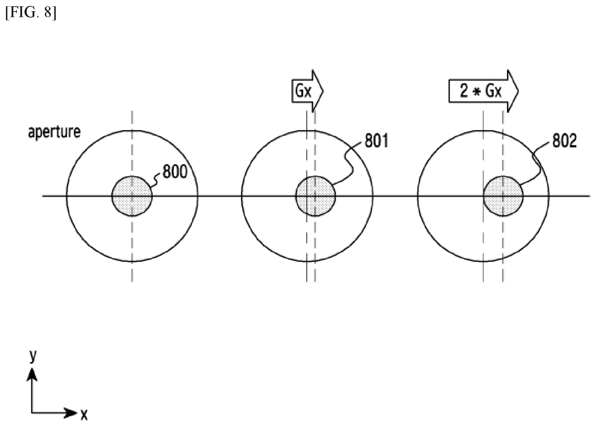

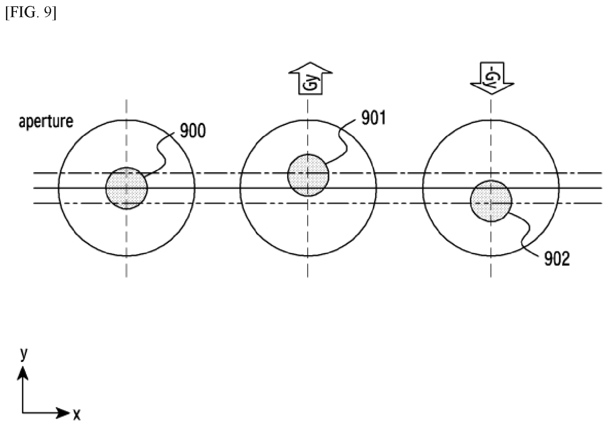

FIGS. 8 and 9 illustrate OIS operations of an electronic device according to an embodiment.

The gyro sensor 330 according to an embodiment may detect acceleration acting along three axes (for example, X-axis, Y-axis or Z-axis) of the electronic device 101, and the OIS operation may be performed on two axes (for example, X-axis or Y-axis). FIGS. 8 and 9 illustrate positions at which the lens assembly 210 is disposed by performing an OIS operation based on an X-axis component and a Y-axis component of the gyro sensor 330.

According to an embodiment, when a value of motion data acquired from the gyro sensor is 0, the electronic device 101 may perform an OIS operation to control an OIS position (for example, a position of the lens assembly in the x-axis/y-axis direction) to position the center of the lens at a first position (for example, 800 of FIG. 8, 900 of FIG. 9) which is the center of the aperture of the lens).

According to an embodiment, when motion data acquired from the gyro sensor includes an x-axis direction acceleration value Gx of a first size, the electronic device 101 may perform an OIS operation to control an OIS position (for example, a position of the lens assembly in the x-axis direction) to position the center of the lens at a second position 801 which is shifted from the center of the aperture of the lens.

According to an embodiment, when motion data acquired from the gyro sensor includes an x-axis direction acceleration value 2Gx of a second size which is larger than the first size, the electronic device 101 may perform an OIS operation to control an OIS position (for example, a position of the lens assembly in the x-axis direction) to position the center of the lens at a third position 802 which is shifted from the center of the aperture of the lens further than the second position 801.

According to an embodiment, when motion data acquired from the gyro sensor includes a y-axis direction acceleration value Gy, the electronic device 101 may perform an OIS operation to control an OIS position (for example, a position of the lens assembly in the y-axis direction) to position the center of the lens at a fourth position 901 that is shifted from the center of the aperture of the lens in the y-axis direction.

According to an embodiment, when motion data acquired from the gyro sensor includes a -y-axis direction acceleration value -Gy, the electronic device 101 may perform an OIS operation to control an OIS position (for example, a position of the lens assembly in the y-axis direction) to position the center of the lens at a fifth position 902 that is shifted from the center of the aperture of the lens in the -y-axis direction.

According to an embodiment, the electronic device may perform an OIS operation based on motion data, and accordingly, the electronic device may be configured to perform an operation of determining whether to perform shading correction based on motion data (for example, operation 705 of FIG. 7). In an embodiment, the electronic device may be configured to perform an operation (for example, operation 705 of FIG. 7) of determining whether to perform shading correction based on a parameter (for example, a parameter indicating an OIS position) acquired through a hall sensor (for example, the hall sensor 320 of FIG. 3) disposed in the optical image stabilizer.

The electronic device according to an embodiment may determine whether to perform shading correction by identifying an OIS position based on at least one of an OIS motion direction or parameter. The electronic device may compare a direction of OIS and a direction of AF detection (phase difference direction). When a phase difference direction is not consistent with an OIS decentering direction and is perpendicular thereto, the electronic device may not perform shading correction even if the lens assembly is position in a specific direction. This is because there is shading in the vertical direction of the phase difference, but the shading in the horizontal direction is minimal or nonexistent.

FIG. 10 illustrates examples of determining whether to perform shading correction according to an OIS operation direction when a phase difference in the horizontal direction (x-axis direction) is detected.

In an embodiment, data acquired from the image sensor may repeatedly include the pattern shown in FIG. 10. For example, the data illustrated in FIG. 10 may indicate data that has a designated pattern and is acquired from the image sensor. The designated pattern may include a pattern in which photo diodes of a 2X2 array disposed at a position corresponding to a single micro lens are repeated. The designated pattern may include a pattern in which micro lens of a 2X2 array disposed to correspond to the same color pattern are repeated. Accordingly, the designated pattern may indicate that the photo diodes of a 4X4 array are disposed to correspond to the same color pattern. Referring to FIG. 10, a pattern may be formed in the data in the unit of a 4X4 array. The pattern illustrated in FIG. 10 may indicate a pattern of pixel values included in the acquired data.

In first data 910 that is configured based on information acquired from photo diodes of the image sensor when an OIS operation is performed in the Y-axis direction, shading included in values acquired from photo diodes disposed in the horizontal direction 911 may be minimal or nonexistent (that is, shading in the horizontal direction may be minimal or nonexistent). Accordingly, the influence of shading on detection of a phase difference in the horizontal direction (x-axis direction) is so low that the electronic device omits the operation of performing shading correction and performs an AF operation.

In second data 920 that is configured based on information acquired from photo diodes of the image sensor when an OIS operation is performed in the X-axis direction and the Y-axis direction (for example, when the camera module is moved diagonally relative to the X-axis and the Y-axis), shading occurring in values acquired from the photo diodes disposed in the vertical and horizontal directions 921 may be included (that is, shading in the horizontal/vertical direction may occur). Accordingly, shading may influence phase difference detection in the horizontal direction (x-axis direction), and therefore, the electronic device may perform an AF operation based on AF data for which shading correction is performed.

In third data 930 that is configured based on information acquired from photo diodes of the image sensor when an OIS position is at the center (for example, the first position 800, 900 of FIG. 8 or 9), shading caused by the OIS operation does not occur, and therefore, the electronic device may omit the operation of performing shading correction and may perform an AF operation.

In fourth data 940 that is configured based on information acquired from photo diodes of the image sensor when an OIS operation is performed in the X-axis direction, shading may be included in values acquired from the photo diodes disposed in the horizontal direction 941 (that is, shading in the horizontal direction may occur). Accordingly, shading may influence phase difference detection in the horizontal direction (x-axis direction), and therefore, the electronic device may perform an AF operation based on AF data for which shading correction is performed.

In an embodiment, when the phase difference direction and the OIS direction are consistent, it may be controlled whether shading correction is performed and how much shading is corrected. However, an electronic device including a 4PD sensor may adjust a phase difference calculation direction according to a correction-required direction only when the phase difference direction is not important. Accordingly, shading correction may be omitted as the calculation direction is changed.

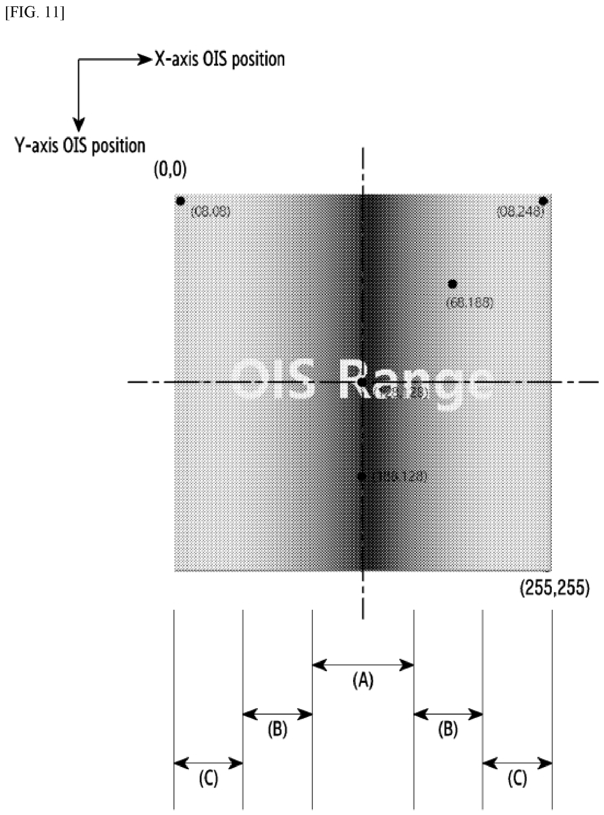

FIG. 11 illustrates an example of a weighting determined based on an OIS position according to an embodiment.

The brightness correction value for each of MxN pixels for performing shading correction may vary according to an OIS position. Brightness correction values may be assigned to MxN pixels in the lookup table (LUT), and each correction value may be determined considering CRA characteristics of a micro lens provided per unit pixel.

Coordinate values shown in FIG. 11 may indicate OIS positions. As brightness increases with the OIS range shown in FIG. 11, a weighting may increase.

FIG. 11 illustrates a weighting distribution applied when the operation direction of OIS is along the X-axis. For example, when the OIS operation causes significant decentering in the X-axis direction (section C), the correction value assigned to the LUT may be increased. To the contrary, when the OIS operation causes weak decentering in the X-axis direction (section A), the correction value assigned to the LUT may be reduced. When the OIS operation causes moderate decentering in the X-axis direction (section B), an average value may be applied considering the correction values used in sections A and C.

By determining a correction value for performing shading correction using the weighting illustrated in FIG. 11, the electronic device may perform shading correction without storing a LUT for all OIS positions. Accordingly, usage for the storage capacity of the memory may be saved.

The technical object to be achieved by the disclosure is not limited to those mentioned above, and other technical objects that are not mentioned above may be clearly understood to those skilled in the art to which the disclosure belongs.

According to an embodiment, an electronic device (for example, the electronic device 101 of FIG. 1, the electronic device 101 of FIG. 3) may include a sensor which outputs a signal for acquiring motion data corresponding to a motion of the electronic device. The electronic device (for example, the electronic device 101 of FIG. 1, the electronic device 101 of FIG. 3) according to an embodiment may include a camera module (for example, the camera module 180 of FIG. 1, the camera module 180 of FIG. 2) including a lens assembly (for example, the lens assembly 210 of FIG. 2 and the lens assembly 210 of FIG. 3) including at least one lens, an image sensor (for example, the image sensor 230 of FIG. 2, the image sensor 230 of FIG. 3), and an optical image stabilizer (OIS) configured to move at least one of the lens assembly or the image sensor to perform an OIS operation based on the motion data. The electronic device (for example, the electronic device 101 of FIG. 1, the electronic device 101 of FIG. 3) according to an embodiment may include a processor (for example, the processor 120 of FIG. 1, the processor 120 of FIG. 3) and a memory which stores instructions that are executable by the processor. The instructions according to an embodiment may cause the electronic device to acquire first AF data from the image sensor. The instructions according to an embodiment may cause the electronic device to generate second AF data by correcting the first AF data based on a parameter for the OIS operation. The instructions according to an embodiment may cause the electronic device to perform an auto focus (AF) function based on the second AF data.

According to an embodiment, the parameter may include a first displacement value and a second displacement value which are coordinate values of the center of the lens assembly (for example, 210 of FIG. 2 and 210 of FIG. 3) that are defined based on the center of the image sensor (for example, 230 of FIG. 2, 230 of FIG. 3) as a reference point.

According to an embodiment, the instructions may cause the electronic device to acquire a look up table (LUT) corresponding to at least one of the parameter or a chief ray angle (CRA) of the at least one lens, and to correct the first AF data based on the LUT.

According to an embodiment, the instruction causes the electronic device to identify a phase difference direction of the first AF data, and to determine whether to perform the correction based on a relationship between the phase difference direction and the parameter.

According to an embodiment, the instructions may cause the electronic device to omit the correction when the relationship between the phase difference direction and the parameter corresponds to a vertical relationship.

According to an embodiment, the instructions may cause the electronic device to adjust weightings of the LUT for the correction when the relationship between the phase difference direction and the parameter corresponds to a horizontal relationship.

According to an embodiment, the instructions may cause the electronic device to change the direction of phase difference detection based on the first AF data when a direction of movement of the at least one lens caused by the OIS operation is maintained for a defined time or more.

According to an embodiment, the instructions may cause the electronic device to perform the AF function based on a first phase difference and a second phase difference which are included in the second AF data having a brightness value changed. The first phase difference may indicate a phase difference in a first direction, and the second phase difference may indicate a phase difference in a second direction which is different from the first direction.

According to an embodiment, the image sensor (for example, 230 of FIG. 2, 230 of FIG. 3) may include a plurality of unit pixels, and each unit pixel may include four or more photo diodes (PDs), and the PDs may be arranged adjacent to one another in the first direction and in the second direction different from the first direction, and each unit pixel may include at least one color filter formed above the four or more PDs included in the unit pixel, and at least one micro lens formed above the at least one color filter.

According to an embodiment, the first direction may be perpendicular to the second direction.

An operating method of an electronic device (for example, 101 of FIG. 1, 101 of FIG. 3) according to an embodiment may include outputting a signal for acquiring motion data corresponding to a motion of the electronic device. The operating method of the electronic device (for example, 101 of FIG. 1, 101 of FIG. 3) according to an embodiment may include controlling a lens assembly (for example, 210 of FIG. 2 and 210 of FIG. 3) or an image sensor (for example, 230 of FIG. 2, 230 of FIG. 3) to perform an optical image stabilization (OIS) operation based on the motion data. The operating method of the electronic device (for example, 101 of FIG. 1, 101 of FIG. 3) according to an embodiment may include acquiring first AF data from the image sensor (for example, 230 of FIG. 2, 230 of FIG. 3). The operating method of the electronic device (for example, 101 of FIG. 1, 101 of FIG. 3) according to an embodiment may include generating second AF data by correcting the first AF data based on a parameter for the OIS operation. The operating method of the electronic device (for example, 101 of FIG. 1, 101 of FIG. 3) according to an embodiment may include performing an auto focus (AF) function based on the second AF data.

According to an embodiment, the parameter may include a first displacement value and a second displacement value which are coordinate values of the center of the lens assembly that are defined based on the center of the image sensor as a reference point.

According to an embodiment, the operating method of the electronic device may further include: acquiring a look up table (LUT) corresponding to at least one of the parameter or a chief ray angle (CRA) of the at least one lens; and correcting the first AF data based on the LUT.

According to an embodiment, the operating method of the electronic device may further include: identifying a phase difference direction of the first AF data; and determining whether to perform the correction based on a relationship between the phase difference direction and the parameter.

According to an embodiment, the operating method of the electronic device may omit generating the second AF data when the relationship between the phase difference direction and the parameter corresponds to a vertical relationship.

According to an embodiment, the operating method of the electronic device may further include adjusting weightings of the LUT for the correction when the relationship between the phase difference direction and the parameter corresponds to a horizontal relationship.

According to an embodiment, the operating method of the electronic device may further include changing the direction of phase difference detection based on the first AF data when a direction of movement of the at least one lens caused by the OIS operation is maintained for a defined time or more.

According to an embodiment, the operating method of the electronic device may further include performing the AF function based on a first phase difference and a second phase difference which are included in the second AF data having a brightness value changed. The first phase difference may indicate a phase difference in a first direction, and the second phase difference may indicate a phase difference in a second direction which is different from the first direction.

According to an embodiment, the image sensor may include a plurality of unit pixels, and each unit pixel may include four or more photo diodes (PDs), and the PDs may be arranged adjacent to one another in the first direction and in the second direction different from the first direction, and each unit pixel may include at least one color filter formed above the four or more PDs included in the unit pixel, and at least one micro lens formed above the at least one color filter.

According to an embodiment, the first direction may be perpendicular to the second direction.

The electronic device and the operating method thereof according to embodiments of the disclosure may enhance the accuracy of the auto focus function performed by the electronic device to capture images.

The electronic device and the operating method thereof according to embodiments of the disclosure may enhance the accuracy of the auto focus function by correcting auto focus data based on a situation in which the electronic device captures images. For example, the accuracy of the auto focus function may be enhanced in situations where an image is captured while tracking a subject, an image is captured while panning a camera, a super-resolution image is captured using an optical image stabilizer, or a panoramic image is captured.

The effect achieved by the disclosure is not limited to those mentioned above, and other effects that are not mentioned above may be clearly understood to those skilled in the art to which the disclosure belongs.

## Claims

1. An electronic device comprising:
a sensor configured to output a signal for acquiring motion data corresponding to a motion of the electronic device;
a camera module comprising: a lens assembly comprising at least one lens; an image sensor; and an optical image stabilizer (OIS) configured to move at least one of the lens assembly or the image sensor to perform an OIS operation based on the motion data;
a processor;
a memory configured to store instructions that are executable by the processor,
wherein the instructions cause the electronic device to:
acquire first AF data from the image sensor;
generate second AF data by correcting the first AF data based on a parameter for the OIS operation; and
perform an auto focus (AF) function based on the second AF data.

2. The electronic device of claim 1, wherein the parameter comprises a first displacement value and a second displacement value which are coordinate values of the center of the lens assembly that are defined based on the center of the image sensor as a reference point.

3. The electronic device of claim 2, wherein the at least one instruction causes the electronic device to:
acquire a look up table (LUT) corresponding to at least one of the parameter or a chief ray angle (CRA) of the at least one lens; and
correct the first AF data based on the LUT.

4. The electronic device of claim 2, wherein the at least one instruction causes the electronic device to:
identify a phase difference direction of the first AF data; and
determine whether to perform the correction based on a relationship between the phase difference direction and the parameter.

5. The electronic device of claim 4, wherein the at least one instruction causes the electronic device to omit the correction when the relationship between the phase difference direction and the parameter corresponds to a vertical relationship.

6. The electronic device of claim 4, wherein the at least one instruction causes the electronic device to adjust weightings of the LUT for the correction when the relationship between the phase difference direction and the parameter corresponds to a horizontal relationship.

7. The electronic device of claim 1, wherein the at least one instruction causes the electronic device to change the direction of phase difference detection based on the first AF data when a direction of movement of the at least one lens caused by the OIS operation is maintained for a defined time or more.

8. The electronic device of claim 1, wherein the at least one instruction causes the electronic device to perform the AF function based on a first phase difference and a second phase difference which are included in the second AF data having a brightness value changed, and
wherein the first phase difference indicates a phase difference in a first direction, and the second phase difference indicates a phase difference in a second direction which is different from the first direction.

9. The electronic device of claim 1, wherein the image sensor comprises a plurality of unit pixels, and each unit pixel comprises four or more photo diodes (PDs), and the PDs are arranged adjacent to one another in a first direction and in a second direction different from the first direction, and
wherein each unit pixel comprises at least one color filter formed above the four or more PDs included in the unit pixel, and at least one micro lens formed above the at least one color filter.

10. The electronic device of claim 9, wherein the first direction is perpendicular to the second direction.

11. An operating method of an electronic device, the method comprising:
outputting a signal for acquiring motion data corresponding to a motion of the electronic device;
controlling a lens assembly or an image sensor to perform an optical image stabilization (OIS) operation based on the motion data;
acquiring first AF data from the image sensor;
generating second AF data by correcting the first AF data based on a parameter for the OIS operation; and
performing an auto focus (AF) function based on the second AF data.

12. The operating method of claim 11, wherein the parameter comprises a first displacement value and a second displacement value which are coordinate values of the center of the lens assembly that are defined based on the center of the image sensor as a reference point.

13. The operating method of claim 12, further comprising:
acquiring a look up table (LUT) corresponding to at least one of the parameter or a chief ray angle (CRA) of the at least one lens; and
correcting the first AF data based on the LUT.

14. The operating method of claim 12, further comprising:
identifying a phase difference direction of the first AF data; and
determining whether to perform the correction based on a relationship between the phase difference direction and the parameter.

15. The operating method of claim 14, wherein generating the second AF data is omitted when the relationship between the phase difference direction and the parameter corresponds to a vertical relationship.
